# EUROPEAN PATENT APPLICATION

(11) **EP 4 716 424 A1**
(43) Date of publication of application: **25.03.2026**
(21) Application number: 25796639.0
(22) Date of filing: 18.04.2025
(51) Int. Cl.: H10F 77/30

(54) **SOLAR CELL, SOLAR CELL PASSIVATION CONTACT STRUCTURE, CELL ASSEMBLY, AND PHOTOVOLTAIC SYSTEM**

(30) Priority: 09.07.2024 CN 202410911352
(71) Applicant: Zhejiang Aiko Solar Energy Technology Co., Ltd., Jinhua, Zhejiang 322000 (CN)
(72) Inventor: WANG, Yongqian, Jinhua, Zhejiang 322000 (CN); ZHANG, Shengli, Jinhua, Zhejiang 322000 (CN)
(74) Representative: EP&C
(86) International application number: PCT/CN2025/089915
(87) International publication number: WO 2026/011883

(57) **Abstract**

The present disclosure is applicable to the technical field of solar cells. Provided are a solar cell and a passivation contact structure thereof, a solar module and a photovoltaic system, and the solar cell passivation contact structure includes a first passivation layer, a first doped polysilicon layer, a first barrier layer and a second doped polysilicon layer which are sequentially stacked on a surface of a silicon substrate; a doping polarity of the first doped polysilicon layer is same as that of the second doped polysilicon layer; and a thickness of the first passivation layer is greater than that of the first barrier layer. The solar cell passivation contact structure according to the present disclosure is additionally provided with the first barrier layer and the second doped polysilicon layer; the first passivation layer and the first barrier layer are used together to prevent impurities from diffusing into the silicon substrate, thereby reducing the inner diffusion of impurities into the silicon substrate, so that the passivation effect of the solar cell can be obviously improved, thereby improving the cell efficiency.

## Description

The present disclosure takes the patent document with the application no. 2024109113526 submitted on July 09, 2012 and entitled "Solar Cell, Passivation Contact Structure thereof, Solar Module and Photovoltaic System" as the priority document, and the disclosure of which is incorporated herein by reference in its entirety.

### Technical Field

The present disclosure relates to the technical field of solar cells, and in particular, to a solar cell, a passivation contact structure thereof, a solar module, and a photovoltaic system.

### Background

A solar cell can convert sunlight into electrical energy by utilizing the photovoltaic effect of a semiconductor, and the solar cell mainly includes a bifacial solar cell and a back contact solar cell. The back contact solar cell, with both the positive and negative electrodes designed on the back surface of the cell, completely avoids the shading of metal grid lines on the front surface compared to bifacial solar cells, eliminating optical losses caused by shading of metal grid lines and significantly improving cell conversion efficiency.

In the related art known to the inventor, the solar cell passivation contact structure typically includes a passivation layer and a doped polysilicon layer sequentially stacked on the surface of a silicon substrate, with the metal electrode of the solar cell being in contact with the doped polysilicon layer, to achieve passivated contact of the solar cell. However, the solar cell passivation contact structure is generally configured as a combination of a single-layer doped polysilicon layer and a single-layer passivation layer; during the solar cell manufacturing process, particularly when the metal electrode is formed in a metallization process, impurities in the metal electrodes, such as iron, copper, cobalt, nickel, and chromium, easily diffuse into the silicon substrate, resulting in a poor passivation effect of the solar cell passivation contact structure, and affecting the solar cell efficiency.

### Summary

The present disclosure provides a solar cell and a passivation contact structure thereof, a solar module and a photovoltaic system, which are intended to solve the problems in the related art that the solar cell passivation contact structure has a poor passivation effect and affects the cell efficiency.

The present disclosure is implemented as follows: provided is a solar cell passivation contact structure, including a first passivation layer, a first doped polysilicon layer, a first barrier layer and a second doped polysilicon layer which are sequentially stacked on a surface of a silicon substrate, where a doping polarity of the first doped polysilicon layer is same as that of the second doped polysilicon layer, and a thickness of the first passivation layer is greater than that of the first barrier layer.

Preferably, a ratio of the thickness of the first passivation layer to that of the first barrier layer is 1 to 10 and not equal to 1.

Preferably, a ratio of the thickness of the first passivation layer to that of the first barrier layer is 1 to 4 and not equal to 1.

Preferably, a ratio of the thickness of the first passivation layer to that of the first barrier layer is 1 to 2 and not equal to 1.

Preferably, the thickness of the first passivation layer is 0.5 to 5 nm, and the thickness of the first barrier layer is 0.2 to 4.5 nm.

Preferably, the first passivation layer is provided with through holes, and the first doped polysilicon layer is in contact with the silicon substrate through the through holes of the first passivation layer.

Preferably, the first barrier layer is provided with through holes, and the second doped polysilicon layer is in contact with the first doped polysilicon layer through the through holes of the first barrier layer.

Preferably, both the first passivation layer and the first barrier layer are provided with through holes, and a through hole density of the first passivation layer is less than that of the first barrier layer.

Preferably, both the first passivation layer and the first barrier layer are provided with through holes, and an average diameter of the through holes of the first passivation layer is less than an average diameter of the through holes of the first barrier layer.

Preferably, the first passivation layer includes one or a combination of silicon oxide containing boron, phosphorus or gallium, silicon oxynitride containing boron, phosphorus or gallium, and silicon nitride containing boron, phosphorus or gallium.

Preferably, the first barrier layer includes one or a combination of silicon oxide containing boron, phosphorus or gallium, silicon oxynitride containing boron, phosphorus or gallium, silicon nitride containing boron, phosphorus or gallium, oxygen-rich silicon containing boron, phosphorus or gallium, and nitrogen-rich silicon containing boron, phosphorus or gallium.

Preferably, an oxygen content of the oxygen-rich silicon is 1×10¹⁹ atoms/cm³ or more.

Preferably, a nitrogen content of the nitrogen-rich silicon is 1×10¹⁹ atoms/cm³ or more.

Preferably, the first passivation layer, the first doped polysilicon layer, the first barrier layer and the second doped polysilicon layer are all doped with group IIIA or group VA elements; and a doping concentration of the second doped polysilicon layer is greater than that of the first doped polysilicon layer.

Preferably, the doping concentration of the first passivation layer is less than or equal to that of the first barrier layer.

Preferably, a thickness of the first doped polysilicon layer is greater than a thickness of the second doped polysilicon layer.

Preferably, a ratio of a thickness of the first doped polysilicon layer to a thickness of the second doped polysilicon layer is 1 to 50.

Preferably, the ratio of the thickness of the first doped polysilicon layer to the thickness of the second doped polysilicon layer is 2 to 50.

Preferably, the ratio of the thickness of the first doped polysilicon layer to the thickness of the second doped polysilicon layer is 5 to 50.

Preferably, a ratio of the thickness of the first doped polysilicon layer to the thickness of the second doped polysilicon layer is 10 to 50.

Preferably, the thickness of the first doped polysilicon layer is 30 to 350 nm, and the thickness of the second doped polysilicon layer is 5 to 150 nm.

Preferably, a thickness of the first doped polysilicon layer is less than that of the second doped polysilicon layer.

Preferably, the solar cell passivation contact structure further includes:
a second barrier layer provided on a side of the second doped polysilicon layer facing away from the silicon substrate.

Preferably, a thickness of the second barrier layer is less than or equal to that of the first barrier layer.

Preferably, the solar cell passivation contact structure further includes:
a third doped polysilicon layer provided on a side of the second barrier layer facing away from the silicon substrate, a doping polarity of the third doped polysilicon layer being the same as or opposite to the doping polarity of the second doped polysilicon layer.

Preferably, the solar cell passivation contact structure further includes:
a third barrier layer provided on a side of the third doped polysilicon layer facing away from the silicon substrate.

Preferably, the solar cell passivation contact structure further includes:
a fourth doped polysilicon layer provided on a side of the third barrier layer facing away from the silicon substrate, a doping polarity of the fourth doped polysilicon layer being the same as or opposite to the doping polarity of the second doped polysilicon layer.

Preferably, a thickness of the third barrier layer is less than or equal to that of the second barrier layer.

Preferably, both the first barrier layer and the second doped polysilicon layer are discontinuously provided on the first doped polysilicon layer.

Preferably, the thicknesses of the first doped polysilicon layer, the second doped polysilicon layer, the third doped polysilicon layer, and the fourth doped polysilicon layer decrease sequentially.

Preferably, the solar cell passivation contact structure further includes:
a plurality of first metal electrodes provided on the second doped polysilicon layer, the plurality of first metal electrodes being in contact with the second doped polysilicon layer.

Preferably, the plurality of first metal electrodes pass through the second doped polysilicon layer and the first barrier layer to be in contact with the first doped polysilicon layer.

Preferably, a width of the first metal electrode in a region of the first doped polysilicon layer is less than that of the first metal electrode in a region of the second doped polysilicon layer.

The present disclosure further provides a solar cell, including a silicon substrate, where the silicon substrate includes a light-facing surface and a backlight surface provided opposite the light-facing surface, and at least one of the light-facing surface and the backlight surface is provided with the described solar cell passivation contact structure.

Preferably, the solar cell is a back contact solar cell, the backlight surface of the back contact solar cell is provided with a P region and an N region, and at least one of the P region and the N region is provided with the solar cell passivation contact structure.

Preferably, the P region is provided with the solar cell passivation contact structure, the N region is provided with a third passivation layer and a sixth doped polysilicon layer provided on a surface of the third passivation layer facing away from the silicon substrate; the first doped polysilicon layer of the solar cell passivation contact structure of the P region is P-type doped polysilicon, and the sixth doped polysilicon layer is N-type doped polysilicon.

Preferably, both the P region and the N region are provided with the solar cell passivation contact structure, the first doped polysilicon layer of the solar cell passivation contact structure in the P region is P-type doped polysilicon, and the first doped polysilicon layer of the solar cell passivation contact structure in the N region is N-type doped polysilicon.

The present disclosure further provides a solar module, including the described solar cell.

The present disclosure further provides a photovoltaic system including the described solar module.

The present disclosure provides the solar cell passivation contact structure, including the first passivation layer, the first doped polysilicon layer, the first barrier layer and the second doped polysilicon layer which are sequentially stacked on the surface of the silicon substrate; by adding the first barrier layer and the second doped polysilicon layer on the surface of the first doped polysilicon layer, the combined blocking effect of the first passivation layer and the first barrier layer is utilized to prevent excessive diffusion of impurities from the metal electrodes, such as iron, copper, cobalt, nickel, and chromium, into the silicon substrate, which significantly enhances the passivation effect of the solar cell, thereby improving cell efficiency; in addition, the first barrier layer can block the metal electrode paste, reducing the burn-through depth of the metal electrode paste and preventing the metal electrodes from burning through the first barrier layer into the first doped polysilicon layer, thus improving the cell yield;
furthermore, the thickness of the first passivation layer is set to be greater than that of the first barrier layer; by reducing the thickness of the first barrier layer, it facilitates the diffusion of doping atoms from the first doped polysilicon layer and the second doped polysilicon layer through the first barrier layer; doping atoms from the one of the first doped polysilicon layer and the second doped polysilicon layer with a higher doping concentration can diffuse through the first barrier layer to the one of the first doped polysilicon layer and the second doped polysilicon layer with a lower doping concentration, thereby better adjusting the doping concentrations of the first doped polysilicon layer and the second doped polysilicon layer, which further enhances the passivation effect of the solar cell passivation contact structure; this not only allows the first barrier layer to block impurities from the metal electrodes and prevent burn-through by the metal electrode paste, but also facilitates the adjustment of doping concentrations between the first doped polysilicon layer and the second doped polysilicon layer, achieving a balance between both effects and thereby further enhancing the efficiency of the solar cell.

### Brief Description of the Drawings

Fig. 1 is a partial schematic structural diagram of a solar cell passivation contact structure according to Embodiment 1 of the present disclosure;
Fig. 2 is a schematic diagram of a solar cell passivation contact structure according to Embodiment 1 of the present disclosure;
Fig. 3 is a schematic diagram of another solar cell passivation contact structure according to Embodiment 1 of the present disclosure;
Fig. 4 is a schematic diagram of still another solar cell passivation contact structure according to Embodiment 1 of the present disclosure;
Fig. 5 is a partial schematic diagram of the solar cell passivation contact structure shown in Fig. 4;
Fig. 6 is a partial schematic structural diagram of a solar cell passivation contact structure according to Embodiment 2 of the present disclosure;
Fig. 7 is a schematic diagram of a solar cell passivation contact structure according to Embodiment 2 of the present disclosure;
Fig. 8 is a schematic diagram of still another solar cell passivation contact structure according to Embodiment 2 of the present disclosure;
Fig. 9 is a partial schematic structural diagram of a solar cell passivation contact structure according to Embodiment 3 of the present disclosure;
Fig. 10 is a schematic diagram of a solar cell passivation contact structure according to Embodiment 3 of the present disclosure;
Fig. 11 is a schematic diagram of still another solar cell passivation contact structure according to Embodiment 3 of the present disclosure;
Fig. 12 is a partial schematic structural diagram of a solar cell passivation contact structure according to Embodiment 4 of the present disclosure;
Fig. 13 is a schematic structural diagram of a solar cell passivation contact structure according to Embodiment 5 of the present disclosure;
Fig. 14 is a schematic structural diagram of a solar cell according to Embodiment 6 of the present disclosure;
Fig. 15 is a schematic structural diagram of a solar cell according to embodiment 7 of the present disclosure;
Fig. 16 is a schematic structural diagram of a solar cell passivation contact structure according to embodiment 8 of the present disclosure;
Fig. 17 is a schematic top view of the structure of a solar cell according to embodiment 9 of the present disclosure;
Fig. 18 is a schematic cross-sectional diagram taken along line A-A of Fig. 17;
Fig. 19 is a schematic cross-sectional diagram taken along line B-B of Fig. 17.

The drawings include the following reference signs:
10, substrate; 1, first passivation layer; 2, first doped polysilicon layer; 3, first barrier layer; 4, second doped polysilicon layer; 5, second barrier layer; 6, third doped polysilicon layer; 7, third barrier layer; 8, fourth doped polysilicon layer; 9, trench; 11, first metal electrode; 14, second passivation layer; 15, fifth doped polysilicon layer; 17, second metal electrode; 19, third metal electrode; 20, third passivation layer; 21, sixth doped polysilicon layer; 22, isolation region; 25, P region; 26, N region; 28, fourth metal electrode; 100, opening; 101, light-facing surface; 102, backlight surface.

### Detailed Description of the Embodiments

To make the objectives, technical solutions, and advantages of the present disclosure clearer, the present disclosure is further described in details below in combination with the drawings and embodiments. It should be understood that the specific embodiments described herein are only used to explain the present disclosure, and are not intended to limit the present disclosure.

The present disclosure provides a solar cell passivation contact structure, including a first passivation layer, a first doped polysilicon layer, a first barrier layer and a second doped polysilicon layer which are sequentially stacked on a surface of a silicon substrate; by adding the first barrier layer and the second doped polysilicon layer on the surface of the first doped polysilicon layer, the first barrier layer acts to block impurities from the metal electrode, preventing excessive diffusion of impurities from the metal electrode into the silicon substrate, which significantly enhances the passivation effect of the solar cell, thereby improving cell efficiency; in addition, the first barrier layer can block the metal electrode paste, reducing the burn-through depth of the metal electrode paste and preventing the metal electrodes from burning through into the first doped polysilicon layer, thus improving the cell yield; furthermore, the thickness of the first passivation layer is set to be greater than the thickness of the first barrier layer, which allows the first barrier layer to block impurities from the metal electrodes and prevent burn-through by the metal electrode paste, and facilitates the adjustment of doping concentrations between the first doped polysilicon layer and the second doped polysilicon layer, thereby further improving the efficiency of the solar cell.

### Embodiment 1

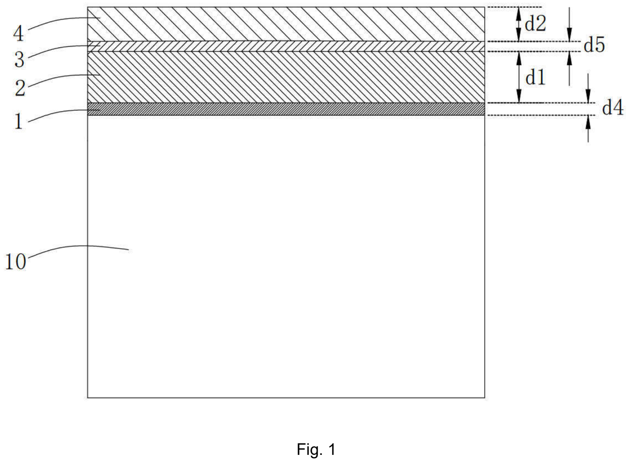

Please refer to Figs. 1-4, an embodiment of the present disclosure provides a solar cell passivation contact structure, including a first passivation layer 1, a first doped polysilicon layer 2, a first barrier layer 3 and a second doped polysilicon layer 4 which are sequentially stacked on a surface of a silicon substrate 10, where a doping polarity of the first doped polysilicon layer 2 is the same as a doping polarity of the second doped polysilicon layer 4, and a thickness d4 of the first passivation layer 1 is greater than a thickness d5 of the first barrier layer 3.

In an embodiment of the present disclosure, the silicon substrate 10 may be a P-type silicon substrate or an N-type silicon substrate. The surface of the silicon substrate 10 may be a light-facing surface or a backlight surface of the solar cell.

In an embodiment of the present disclosure, provided is the solar cell passivation contact structure, including the first passivation layer 1, the first doped polysilicon layer 2, the first barrier layer 3 and the second doped polysilicon layer 4 which are sequentially stacked on the surface of the silicon substrate 10; by adding the first barrier layer 3 and the second doped polysilicon layer 4 on the surface of the first doped polysilicon layer 2, the combined blocking effect of the first passivation layer 1 and the first barrier layer 3 is utilized to prevent excessive diffusion of impurities from the metal electrodes into the silicon substrate, which significantly enhances the passivation effect of the solar cell, thereby improving cell efficiency; in addition, the first barrier layer 3 can block the metal electrode paste, reducing the burn-through depth of the metal electrode paste and preventing the metal electrodes from burning through the first barrier layer 3 into the silicon substrate. The impurities include but are not limited to iron, copper, cobalt, nickel, chromium and other impurities in the metal electrode.

Furthermore, in the present application, the thickness of the first passivation layer 1 is set to be greater than that of the first barrier layer 3; by reducing the thickness of the first barrier layer 3, it facilitates the diffusion of doping atoms from the first doped polysilicon layer 2 and the second doped polysilicon layer 4 through the first barrier layer 3; doping atoms from the one of the first doped polysilicon layer 2 and the second doped polysilicon layer 4 with a higher doping concentration can diffuse through the first barrier layer 3 to one of the first doped polysilicon layer 2 and the second doped polysilicon layer 4 with a lower doping concentration, thereby better adjusting the doping concentrations of the first doped polysilicon layer 2 and the second doped polysilicon layer 4, which further enhances the passivation effect of the solar cell passivation contact structure; this not only allows the first barrier layer 3 to block impurities from the metal electrodes and prevent burn-through by the metal electrode paste, but also facilitates the adjustment of doping concentrations between the first doped polysilicon layer 2 and the second doped polysilicon layer 4, achieving a balance between both effects and thereby further enhancing the efficiency of the solar cell. In addition, in practical applications, by adjusting the doping concentrations and thicknesses of the first doped polysilicon layer 2 and the second doped polysilicon layer 4, the passivation effect can be further optimized, so that the solar cell passivation contact structure can have a better passivation effect, and the solar cell efficiency can be effectively improved.

In the embodiment of the present disclosure, the thickness d4 of the first passivation layer 1 is greater than the thickness d5 of the first barrier layer 3, i.e., the first passivation layer 1 close to the silicon substrate 10 is thicker, which can further improve the passivation effect of the solar cell passivation contact structure, facilitate the diffusion of doping atoms from the first doped polysilicon layer 2 and the second doped polysilicon layer 4 through the first barrier layer 3, better adjust the doping concentrations between the first doped polysilicon layer 2 and the second doped polysilicon layer 4, further improve the passivation effect of the solar cell passivation contact structure, and effectively improve the solar cell efficiency.

In the present embodiment, both the doping polarity of the first doped polysilicon layer 2 and the doping polarity of the second doped polysilicon layer 4 are P type or N type. For example, both the first doped polysilicon layer 2 and the second doped polysilicon layer 4 may be doped with boron element, or both the first doped polysilicon layer 2 and the second doped polysilicon layer 4 may be doped with phosphorus element.

As an embodiment of the present disclosure, the first passivation layer 1, the first doped polysilicon layer 2, the first barrier layer 3 and the second doped polysilicon layer 4 are doped with group IIIA or group VA elements; the doping concentration of the second doped polysilicon layer 4 is greater than that of the first doped polysilicon layer 2.

In the present embodiment, when the solar cell passivation contact structure is provided in the p region of the solar cell, the first passivation layer 1, the first doped polysilicon layer 2, the first barrier layer 3 and the second doped polysilicon layer 4 are doped with group IIIA elements; and when the solar cell passivation contact structure is provided in the N region of the solar cell, the first passivation layer 1, the first doped polysilicon layer 2, the first barrier layer 3 and the second doped polysilicon layer 4 are doped with group VA elements.

In the present embodiment, the doping concentration of the second doped polysilicon layer 4 is greater than that of the first doped polysilicon layer 2, and the second doped polysilicon layer 4 and the first doped polysilicon layer 2 form a high-low junction to provide field-effect passivation; furthermore, the doping concentration of the second doped polysilicon layer 4 is higher than that of the first doped polysilicon layer 2, which facilitates a good ohmic contact between the second doped polysilicon layer 4 and the metal electrodes, improves the passivation effect of the solar cell passivation contact structure, reduces current loss, and thus improves the cell efficiency. In addition, in other embodiments, the doping concentration of the second doped polysilicon layer 4 may also be less than or equal to that of the first doped polysilicon layer 2.

As an embodiment of the present disclosure, the doping concentration of the first passivation layer 1 is less than or equal to that of the first barrier layer 3.

In the present embodiment, the doping concentration of the first passivation layer 1 is less than or equal to that of the first barrier layer 3, which facilitates improving the passivation effect of the first passivation layer 1. In other embodiments, the doping concentration of the first passivation layer 1 may also be greater than that of the first barrier layer 3.

As a preferred embodiment of the present disclosure, the doping concentration of the first passivation layer 1 is less than that of the first barrier layer 3, which facilitates improving the capability of the first barrier layer 3 to prevent impurities from entering the silicon substrate 10.

As an embodiment of the present disclosure, a ratio of the thickness d4 of the first passivation layer 1 to the thickness d5 of the first barrier layer 3 is 1 to 10 and is not equal to 1.

In the present embodiment, a ratio of the thickness d4 of the first passivation layer 1 to the thickness d5 of the first barrier layer 3 is greater than 1 and less than or equal to 10, which ensures effective blocking of impurities and burn-through of metal electrode paste by the first passivation layer 1 and the first barrier layer 3, facilitates the adjustment of doping concentrations between the first doped polysilicon layer 2 and the second doped polysilicon layer 4, enables the solar cell passivation contact structure to achieve a good passivation performance, and also simplifies the manufacturing of the first passivation layer 1 and the first barrier layer 3.

Specifically, the thickness d4 of the first passivation layer 1 and the thickness d5 of the first barrier layer 3 may be set flexibly, as long as the thickness d4 of the first passivation layer 1 is greater than the thickness d5 of the first barrier layer 3, a ratio of the thickness d4 of the first passivation layer 1 to the thickness d5 of the first barrier layer 3 may be 1.01, or 1.5, or 2.0, or 2.4, or 3.0, or 3.5, or 4, or 4.5, or 5, or 5.5, or 6, or 7, or 8, or 9, or 10.

As an embodiment of the present disclosure, a ratio of the thickness d4 of the first passivation layer 1 to the thickness d5 of the first barrier layer 3 is 1 to 4 and is not equal to 1.

In the present embodiment, the ratio of the thickness d4 of the first passivation layer 1 to the thickness d5 of the first barrier layer 3 is greater than 1 and less than or equal to 4, which not only ensures good impurity blocking effect and good passivation effect for the first passivation layer 1 and the first barrier layer 3, but also facilitates the preparation of the first passivation layer 1 and the first barrier layer 3.

As an embodiment of the present disclosure, a ratio of the thickness d4 of the first passivation layer 1 to the thickness d5 of the first barrier layer 3 is 1 to 2 and is not equal to 1.

In the present embodiment, the ratio of the thickness d4 of the first passivation layer 1 to the thickness d5 of the first barrier layer 3 is greater than 1 and less than or equal to 2, which further reduces the thickness difference between the first passivation layer 1 and the first barrier layer 3, facilitates the preparation of the first passivation layer 1 and the first barrier layer 3, and can achieve a good impurity blocking effect and a good passivation effect for the first passivation layer 1 and the first barrier layer 3.

As an embodiment of the present disclosure, the thickness d4 of the first passivation layer 1 is 0.5 to 5 nm, and the thickness d5 of the first barrier layer 3 is 0.2 to 4.5 nm. In addition, the thickness d 4 of the first passivation layer 1 and the thickness d 5 of the first barrier layer 3 are not limited to this range, and the thicknesses of the first passivation layer 1 and the first barrier layer 3 can be set flexibly as required.

In the embodiment, on the premise that the thickness d4 of the first passivation layer 1 is greater than the thickness d5 of the first barrier layer 3, the thickness d4 of the first passivation layer 1 may be 0.5 nm, or 1 nm, or 1.5 nm, or 2.0 nm, or 2.5 nm, or 2.8 nm, or 3.0 nm, or 3.2 nm, or 3.5 nm, or 3.8 nm, or 4.0 nm, or 4.2 nm, or 4.5 nm, or 5 nm.

In the embodiment, the thickness d5 of the first barrier layer 3 may be 0.2 nm, or 0.5 nm, or 1 nm, or 1.5 nm, or 2.0 nm, or 2.5 nm, or 2.8 nm, or 3.0 nm, or 3.2 nm, or 3.5 nm, or 3.8 nm, or 4.0 nm, or 4.2 nm, or 4.5 nm.

As an embodiment of the present disclosure, the first passivation layer 1 is provided with through holes (not shown), and the first doped polysilicon layer 2 is in contact with the silicon substrate 10 through the through holes on the first passivation layer 1.

In the present embodiment, the through holes on the first passivation layer 1 perpendicularly penetrate through the first passivation layer 1. An inner diffusion layer is further provided inside the silicon substrate 10, and the first doped polysilicon layer 2 is in contact with the inner diffusion layer inside the silicon substrate 10 through the through holes on the first passivation layer 1. The first doped polysilicon layer 2 is in contact with the silicon substrate 10 through the through holes on the first passivation layer 1, which facilitates the contact between the first doped polysilicon layer 2 and the silicon substrate 10, reduces current losses, and improves the cell conversion efficiency.

As an embodiment of the present disclosure, the first barrier layer 3 is provided with through holes, and the second doped polysilicon layer 4 passes through the through holes on the first barrier layer 3 to be in contact with the first doped polysilicon layer 2.

In the present embodiment, the through holes of the first barrier layer 3 perpendicularly penetrate through the first barrier layer 3. The second doped polysilicon layer 4 is in contact with the first doped polysilicon layer 2 using the through holes on the first barrier layer 3, which facilitates the contact between the second doped polysilicon layer 4 and the first doped polysilicon layer 2, reduces current losses, and improves the cell conversion efficiency. Furthermore, the through holes on the first barrier layer 3 facilitate the passage of doping atoms of the first doped polysilicon layer 2 and the second doped polysilicon layer 4, and facilitate the adjustment of the doping concentration between the first doped polysilicon layer 2 and the second doped polysilicon layer 4, so as to further improve the solar cell efficiency.

The through holes of the first passivation layer 1 and the first barrier layer 3 may be manufactured by means of chemical etching, dry etching, thermal diffusion impact, or the like, and are manufactured according to actual usage requirements, which is not specifically limited herein. When viewing the first passivation layer 1 and the first barrier layer 3 from a top view angle, the first passivation layer 1 and the first barrier layer 3 are shown as a porous structure, and when viewing the first passivation layer 1 and the first barrier layer 3 from a cross-sectional view angle, the first passivation layer 1 and the first barrier layer 3 are shown as a multi-channel structure. Optionally, the hole diameter of the through holes of the first passivation layer 1 and the first barrier layer 3 is less than 10 µm.

As an embodiment of the present disclosure, both the first passivation layer 1 and the first barrier layer 3 are provided with through holes, and the through hole density of the first passivation layer 1 is less than that of the first barrier layer 3.

In the present embodiment, the through hole density of the first passivation layer 1 is less than that of the first barrier layer 3, which may be understood as that the number of the through holes of the first passivation layer 1 is less than the number of the through holes of the first barrier layer 3 per unit area. Since the through hole density of the first passivation layer 1 is less than that of the first barrier layer 3, the electrical conductivity of the first passivation layer 1 and the electrical conductivity of the first barrier layer 3 can be sequentially enhanced, which facilitates improving the impurity adsorption effect of the silicon substrate 10, and improves the cell efficiency.

As an embodiment of the present disclosure, both the first passivation layer 1 and the first barrier layer 3 are provided with through holes, and the average diameter of the through holes of the first passivation layer 1 is less than that of the through holes of the first barrier layer 3.

The through hole diameters of the through holes of the first passivation layer 1 may be equal or unequal; likewise, the through hole diameters of the through holes of the first barrier layer 3 may be equal or unequal. The average diameter of the through holes of the first passivation layer 1 may be understood as the average diameter of all the through holes of the first passivation layer 1; and the average diameter of the through holes of the first barrier layer 3 can be understood as the average diameter of all the through holes of the first barrier layer 3. By setting the average diameter of the through holes of the first passivation layer 1 to be less than the average diameter of the through holes of the first barrier layer 3, the passivation effect of the first passivation layer 1 on the back surface of the silicon substrate 10 is improved, and the cell efficiency is improved.

As an embodiment of the present disclosure, the first passivation layer 1 includes one or a combination of silicon oxide containing boron, phosphorus or gallium, silicon oxynitride containing boron, phosphorus or gallium, and silicon nitride containing boron, phosphorus or gallium.

In the present embodiment, the first passivation layer 1 may be a silicon oxide containing boron, phosphorus or gallium, or a silicon oxynitride containing boron, phosphorus or gallium, or a silicon nitride containing boron, phosphorus or gallium; the first passivation layer 1 may also be any combination of silicon oxide containing boron, phosphorus or gallium, silicon oxynitride containing boron, phosphorus or gallium, and silicon nitride containing boron, phosphorus or gallium. The first passivation layer 1 is made of the described materials, which not only can achieve a good impurity blocking effect of the first passivation layer 1, but also can achieve a good passivation effect.

As an embodiment of the present disclosure, the first barrier layer 3 includes one or a combination of silicon oxide containing boron, phosphorus or gallium, silicon oxynitride containing boron, phosphorus or gallium, silicon nitride containing boron, phosphorus or gallium, oxygen-rich silicon containing boron, phosphorus or gallium, and nitrogen-rich silicon containing boron, phosphorus or gallium.

In the present embodiment, the first barrier layer 3 may be silicon oxide containing boron, phosphorus or gallium, or silicon oxynitride containing boron, phosphorus or gallium, or silicon nitride containing boron, phosphorus or gallium, or oxygen-rich silicon containing boron, phosphorus or gallium, or nitrogen-rich silicon containing boron, phosphorus or gallium; the first barrier layer 3 may also be any combination of silicon oxide containing boron, phosphorus or gallium, silicon oxynitride containing boron, phosphorus or gallium, silicon nitride containing boron, phosphorus or gallium, oxygen-rich silicon containing boron, phosphorus or gallium, and nitrogen-rich silicon containing boron, phosphorus or gallium. The first barrier layer 3 is made of the described material, and the first barrier layer 3 can not only achieve a good impurity blocking effect, but also achieve a good passivation effect.

As an embodiment of the present disclosure, the oxygen-rich silicon has an oxygen content of 1×10¹⁹ atoms/cm³ or more.

In the present embodiment, when the first barrier layer 3 includes oxygen-rich silicon containing boron, phosphorus or gallium, the oxygen content of the oxygen-rich silicon is more than 1×10¹⁹ atoms/cm ³, which can improve the impurity blocking effect of the first barrier layer 3.

As an embodiment of the present disclosure, when the first barrier layer 3 includes nitrogen-rich silicon containing boron, phosphorus or gallium, the nitrogen content of the nitrogen-rich silicon is not less than 1×10¹⁹ atoms/cm³, which can improve the impurity blocking effect of the first barrier layer 3.

As an embodiment of the present disclosure, the thickness d1 of the first doped polysilicon layer 2 is greater than the thickness d2 of the second doped polysilicon layer 4.

In the present embodiment, the thickness d1 of the first doped polysilicon layer 2 is greater than the thickness d2 of the second doped polysilicon layer 4, so that the doped polysilicon layer close to the silicon substrate 10 has a larger thickness, which facilitates further improving the passivation effect of the solar cell passivation contact structure.

As another embodiment of the present invention, the thickness d1 of the first doped polysilicon layer 2 is less than the thickness d2 of the second doped polysilicon layer 4, so that the function of the second doped polysilicon layer 4 for blocking the metal electrode paste from burning through can be improved, and the metal electrode paste can be prevented from burning through into the first doped polysilicon layer 2. In other embodiments, the thickness d1 of the first doped polysilicon layer 2 may also be equal to the thickness d2 of the second doped polysilicon layer 4.

As an embodiment of the present disclosure, a ratio of the thickness d1 of the first doped polysilicon layer 2 to the thickness d2 of the second doped polysilicon layer 4 is 1 to 50.

In the present embodiment, the ratio of the thickness d1 of the first doped polysilicon layer 2 to the thickness d2 of the second doped polysilicon layer 4 is greater than or equal to 1 and less than or equal to 50, which can ensure a good passivation effect of the solar cell passivation contact structure.

Specifically, the thickness d1 of the first doped polysilicon layer 2 and the thickness d2 of the second doped polysilicon layer 4 can be specifically set flexibly, as long as the ratio of the thickness d1 of the first doped polysilicon layer 2 to the thickness d2 of the second doped polysilicon layer 4 is in the range of 1 to 50. For example, the ratio of the thickness d1 of the first doped polysilicon layer 2 to the thickness d2 of the second doped polysilicon layer 4 may be 1, or 3, or 5, or 6, or 8, or 10, or 12, or 14, or 15, or 16, or 17, or 19, or 20, or 22, or 25, or 28, or 30, or 32, or 35, or 38, or 40, or 42, or 46, or 48, or 50.

As an embodiment of the present disclosure, a ratio of the thickness d1 of the first doped polysilicon layer 2 to the thickness d2 of the second doped polysilicon layer 4 is 2 to 50.

In the present embodiment, the ratio of the thickness d1 of the first doped polysilicon layer 2 to the thickness d2 of the second doped polysilicon layer 4 is greater than or equal to 2 and less than or equal to 50, in this way, the difference between the thickness d1 of the first doped polysilicon layer 2 and the thickness d2 of the second doped polysilicon layer 4 is within an optimal range, which can ensure a better passivation effect of the solar cell passivation contact structure, and further facilitate the manufacturing of the first doped polysilicon layer 2 and the second doped polysilicon layer 4.

As an embodiment of the present disclosure, a ratio of the thickness d1 of the first doped polysilicon layer 2 to the thickness d2 of the second doped polysilicon layer 4 is 5 to 50.

In the present embodiment, the ratio of the thickness d1 of the first doped polysilicon layer 2 to the thickness d2 of the second doped polysilicon layer 4 is greater than or equal to 5 and less than or equal to 50, so that the difference between the thickness d1 of the first doped polysilicon layer 2 and the thickness d2 of the second doped polysilicon layer 4 is larger, which can further improve the passivation effect of the solar cell passivation contact structure.

As an embodiment of the present disclosure, the ratio of the thickness of the first doped polysilicon layer 2 to the thickness of the second doped polysilicon layer 4 is 10 to 50.

In the present embodiment, the ratio of the thickness d1 of the first doped polysilicon layer 2 to the thickness d2 of the second doped polysilicon layer 4 is greater than or equal to 10 and less than or equal to 50, and the difference between the thickness d1 of the first doped polysilicon layer 2 and the thickness d2 of the second doped polysilicon layer 4 is further increased, so that the passivation effect of the solar cell passivation contact structure can be further improved.

As an embodiment of the present disclosure, the thickness d1 of the first doped polysilicon layer 2 is 30 to 350 nm, and the thickness d2 of the second doped polysilicon layer 4 is 5 to 150 nm.

In the present embodiment, the thickness d1 of the first doped polysilicon layer 2 may be any value in the range of 30 to 350 nm, and the thickness d2 of the second doped polysilicon layer 4 may be any value in the range of 5 to 150 nm. For example, the thickness d1 of the first doped polysilicon layer 2 may be 30 nm, and the thickness d2 of the second doped polysilicon layer 4 may be 5 nm; or the thickness d1 of the first doped polysilicon layer 2 may be 300 nm, and the thickness d2 of the second doped polysilicon layer 4 may be 30 nm. For another example, the thickness d1 of the first doped polysilicon layer 2 may be 350 nm, and the thickness d2 of the second doped polysilicon layer 4 may be 150 nm.

As an embodiment of the present disclosure, both the first barrier layer 3 and the second doped polysilicon layer 4 are formed as continuous full-surface structures covering the first doped polysilicon layer 2, that is, the first barrier layer 3 and the second doped polysilicon layer 4 fully cover the surface of the first doped polysilicon layer 2, enabling full-surface passivation.

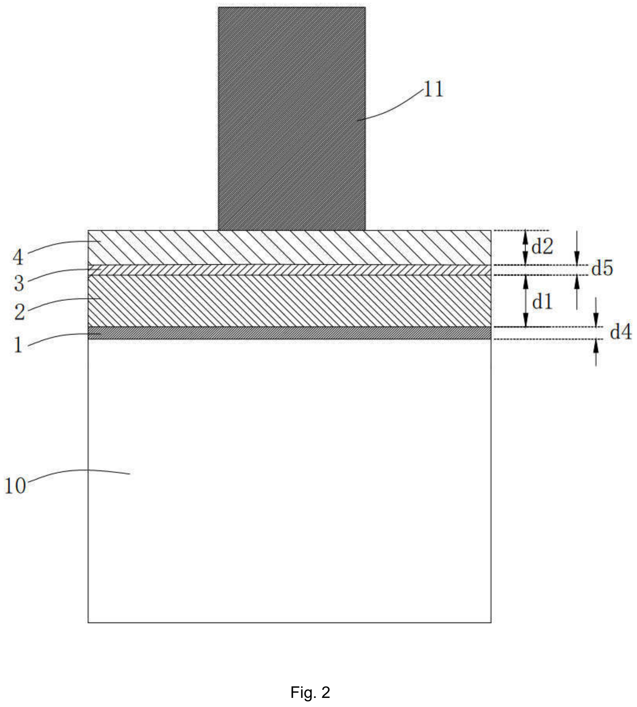

Please refer to Fig. 2, the solar cell passivation contact structure of the present embodiment further includes:
first metal electrodes 11 provided on the second doped polysilicon layer 4, the first metal electrodes 11 being in contact with the second doped polysilicon layer 4.

In the present embodiment, the first barrier layer 3 and the second doped polysilicon layer 4 can block the paste of the first metal electrodes 11, so as to prevent the first metal electrodes 11 from burning through the first barrier layer 3 into the first doped polysilicon layer 2; the first metal electrodes 11 only contact with the second doped polysilicon layer 4, and the depth that the first metal electrodes 11 enter the second doped polysilicon layer 4 is less than the thickness of the second doped polysilicon layer 4. In addition, since the doping polarity of the first doped polysilicon layer 2 is the same as that of the second doped polysilicon layer 4, the first metal electrodes 11 are in direct contact with the second doped polysilicon layer 4, and the second doped polysilicon layer 4 and the first barrier layer 3 are not provided with an opening in advance, so that the first doped polysilicon layer 2 and the second doped polysilicon layer 4 can have a good blocking effect.

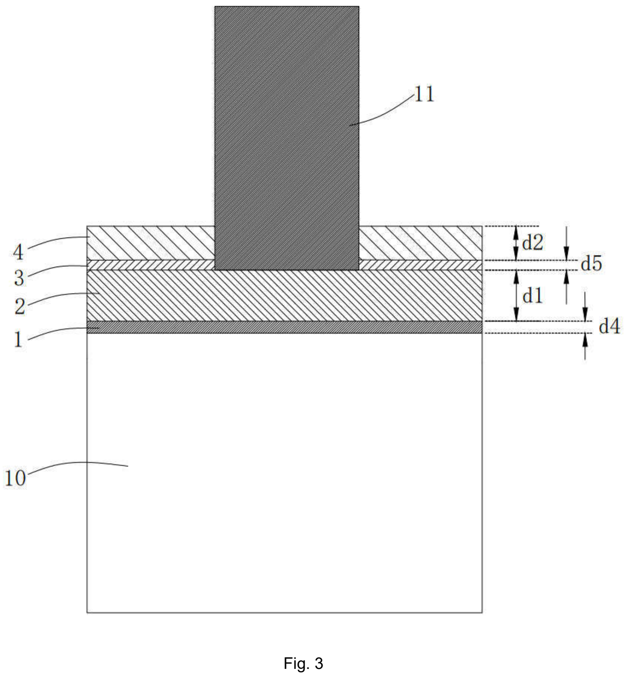

Please refer to Fig. 3, as another embodiment of the present disclosure, the first metal electrodes 11 pass through the second doped polysilicon layer 4 and the first barrier layer 3 to be in contact with the first doped polysilicon layer 2.

In the present embodiment, during the metallization process of the first metal electrodes 11, the first metal electrodes 11 may pass through the second doped polysilicon layer 4 and the first barrier layer 3 to be in contact with the first doped polysilicon layer 2, so that the first metal electrodes 11 simultaneously contact the second doped polysilicon layer 4, the first barrier layer 3 and the first doped polysilicon layer 2. As the second doped polysilicon layer 4 and the first barrier layer 3 are not provided with an opening in advance, the first metal electrodes 11 are in close contact with the second doped polysilicon layer 4 and the first barrier layer 3, which can also ensure an effect that the second doped polysilicon layer 4 and the first barrier layer 3 better block impurities.

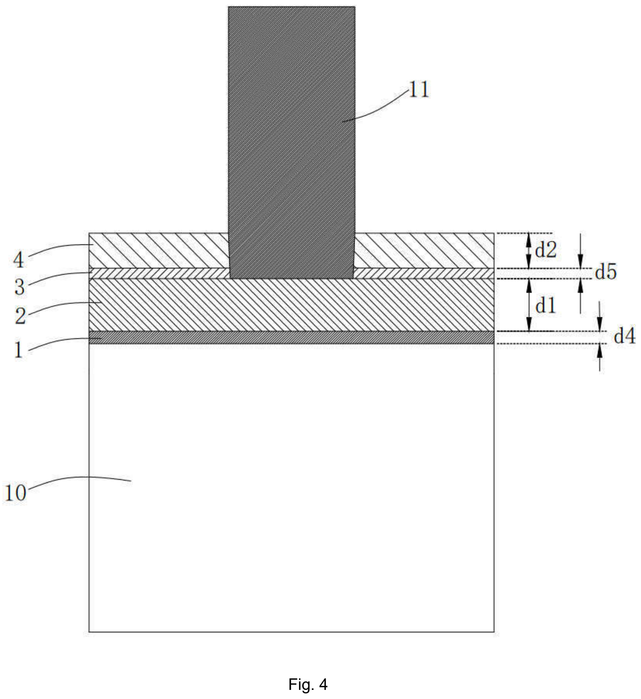

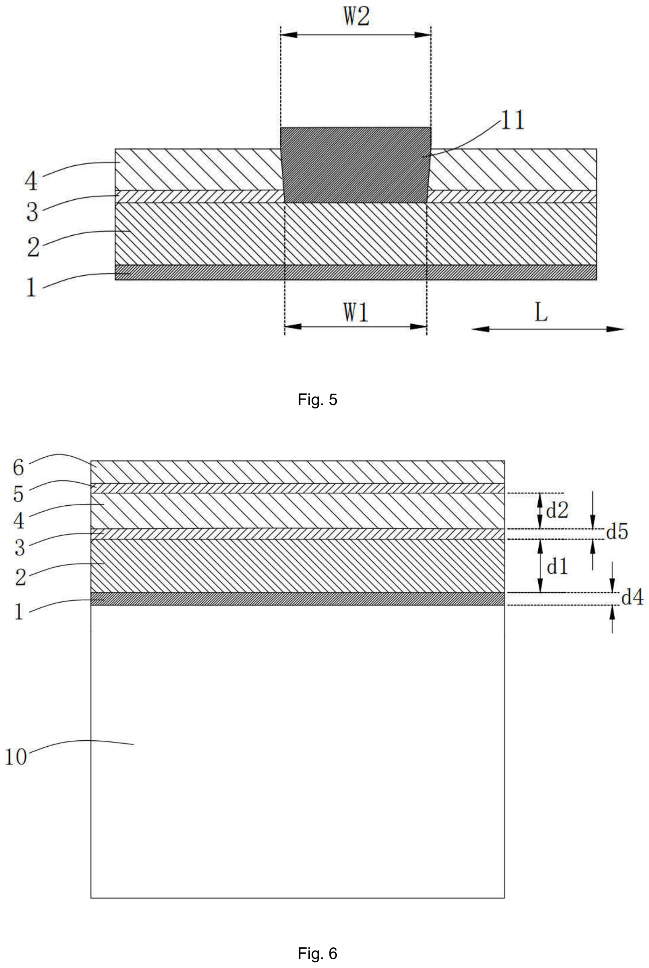

Please refer to Figs. 4 and 5, as an embodiment of the present disclosure, the width of the first metal electrode 11 in the region of the first doped polysilicon layer 2 is less than the width of the first metal electrode 11 in the region of the second doped polysilicon layer 4.

The width of the first metal electrode 11 in the region of the first doped polysilicon layer 2 may be any width of the first metal electrode 11 in the horizontal direction L in the region of the first doped polysilicon layer 2; the width of the first metal electrode 11 in the region of the second doped polysilicon layer 4 may be any width of the first metal electrode 11 in the horizontal direction L in the region of the second doped polysilicon layer 4. Preferably, the width of the first metal electrode 11 in the region of the first doped polysilicon layer 2 is a width W1 of the first metal electrode 11 in the horizontal direction L on the surface of the first doped polysilicon layer 2 facing away from the first passivation layer 1; and the width of the first metal electrode 11 in the region of the second doped polysilicon layer 4 is a width W2 of the first metal electrode 11 in the horizontal direction L on the surface of the second doped polysilicon layer 4 facing away from the first passivation layer 1.

In the present embodiment, due to the blocking effect of the second doped polysilicon layer 4 and the first barrier layer 3, the burning-through depth of the first metal electrodes 11 can be blocked, so that the first metal electrodes 11 gradually decrease from the surface of the second doped polysilicon layer 4 facing away from the first passivation layer 1 towards the first doped polysilicon layer 2, so that the first metal electrodes 11 can be prevented from entering and burning through the first passivation layer 1, thereby preventing the first metal electrodes 11 from being in direct contact with the silicon substrate 10.

### Embodiment 2

Please refer to Fig. 6, on the basis of Embodiment 1, the solar cell passivation contact structure of the present embodiment further includes:
a second barrier layer 5 provided on a side of the second doped polysilicon layer 4 facing away from the silicon substrate 10.

In the present embodiment, by providing the second barrier layer 5 on the surface of the second doped polysilicon layer 4 facing away from the silicon substrate 10, the second barrier layer 5 can be used to further prevent impurities of the metal electrodes from diffusing into the silicon substrate 10, and the second barrier layer 5 can be used to further block the paste of the metal electrodes, thereby further improving the passivation effect of the solar cell passivation contact structure.

As an embodiment of the present disclosure, a thickness of the second barrier layer 5 is less than or equal to that of the first barrier layer 3.

In the present embodiment, the thickness of the second barrier layer 5 may be less than or equal to that of the first barrier layer 3, and in some other embodiments, the thickness of the second barrier layer 5 may also be greater than that of the first barrier layer 3. The material of the second barrier layer 5 may be the same as or different from the material of the first barrier layer 3.

As an embodiment of the present disclosure, the solar cell passivation contact structure further includes:
a third doped polysilicon layer 6 provided on a side of the second barrier layer 5 facing away from the silicon substrate 10, a doping polarity of the third doped polysilicon layer 6 being the same as or opposite to the doping polarity of the second doped polysilicon layer 4.

In the present embodiment, by adding the second barrier layer 5 and the third doped polysilicon layer 6, the impurities of the metal electrodes are prevented from inner diffusion into the silicon substrate 10 by means of the second barrier layer 5, the first barrier layer 3 and the first passivation layer 1; and the burning through of the paste of the metal electrodes is prevented by means of the second barrier layer 5 and the first barrier layer 3, thereby further improving the passivation effect of the solar cell passivation contact structure. Furthermore, the passivation effect of the solar cell passivation contact structure can be further enhanced by means of the third doped polysilicon layer 6.

The doping polarity of the third doped polysilicon layer 6 may be the same as or opposite to that of the second doped polysilicon layer 4.

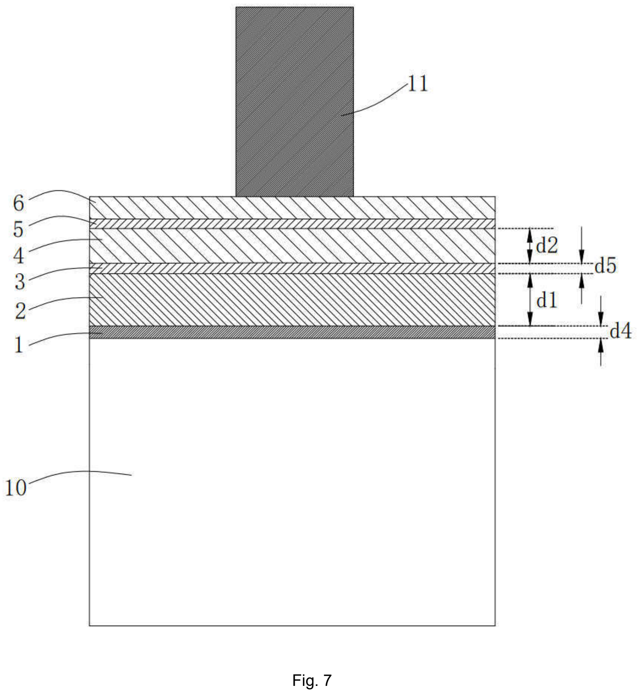

Please refer to Fig. 7, the doping polarity of the third doped polysilicon layer 6 is the same as that of the second doped polysilicon layer 4, that is, the doping polarities of the third doped polysilicon layer 6, the second doped polysilicon layer 4 and the first doped polysilicon layer 2 are all P-type or N-type. In this case, no opening needs to be provided on the third doped polysilicon layer 6, and the first metal electrodes 11 may be in contact with the third doped polysilicon layer 6. Certainly, the first metal electrodes 11 may also pass through the third doped polysilicon layer 6 to be in contact with the second doped polysilicon layer 4 or the first doped polysilicon layer 2.

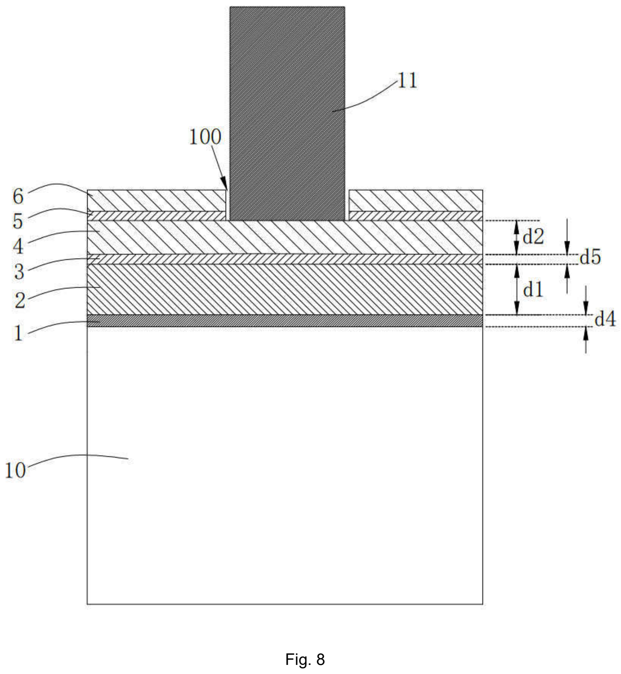

Please refer to Fig. 8, the doping polarity of the third doped polysilicon layer 6 is opposite to that of the second doped polysilicon layer 4, that is, if the doping polarities of the second doped polysilicon layer 4 and the first doped polysilicon layer 2 are P-type, then the doping polarity of the third doped polysilicon layer 6 is N-type; or if the doping polarities of the second doped polysilicon layer 4 and the first doped polysilicon layer 2 are N type, the doping polarity of the third doped polysilicon layer 6 is P type. In this case, the third doped polysilicon layer 6 and the second barrier layer 5 are provided with openings 100, and the first metal electrodes 11 pass through the opening 100 to be in contact with the second doped polysilicon layer 4 or the first doped polysilicon layer 2.

### Embodiment 3

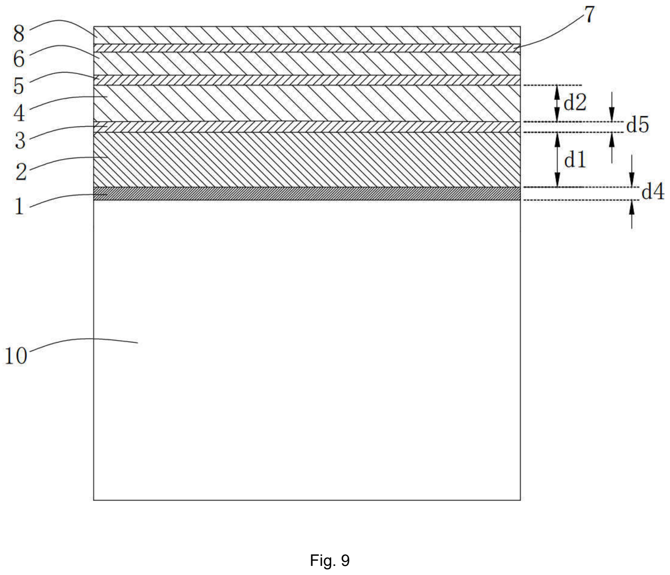

Please refer to Fig. 9, on the basis of Embodiment 2, the solar cell passivation contact structure of the present embodiment further includes:
a third barrier layer 7 provided on a side of the third doped polysilicon layer 6 facing away from the silicon substrate 10.

In the present embodiment, by providing the third barrier layer 7 on the surface of the third doped polysilicon layer 6 facing away from the silicon substrate 10, the third barrier layer 7 can be used to further prevent impurities of the metal electrodes from diffusing into the silicon substrate 10, and the third barrier layer 7 can be used to further block the paste of the metal electrodes, thereby further improving the passivation effect of the solar cell passivation contact structure.

As an embodiment of the present disclosure, the solar cell passivation contact structure further includes:
a fourth doped polysilicon layer 8 provided on a side of the third barrier layer 7 facing away from the silicon substrate 10, a doping polarity of the fourth doped polysilicon layer 8 being the same as or opposite to the doping polarity of the second doped polysilicon layer 4.

In the present embodiment, by adding the third barrier layer 7 and the fourth doped polysilicon layer 8, the impurities of the metal electrodes are prevented from inner diffusion into the silicon substrate 10 by means of the third barrier layer 7, the second barrier layer 5, the first barrier layer 3 and the first passivation layer 1, thereby further improving the passivation effect of the solar cell passivation contact structure. Furthermore, the passivation effect of the solar cell passivation contact structure can be further enhanced by means of the fourth doped polysilicon layer 8.

The doping polarity of the fourth doped polysilicon layer 8 is the same as that of the third doped polysilicon layer 6; and the doping polarity of the fourth doped polysilicon layer 8 may be the same as or opposite to the doping polarities of the second doped polysilicon layer 4 and the first doped polysilicon layer 2.

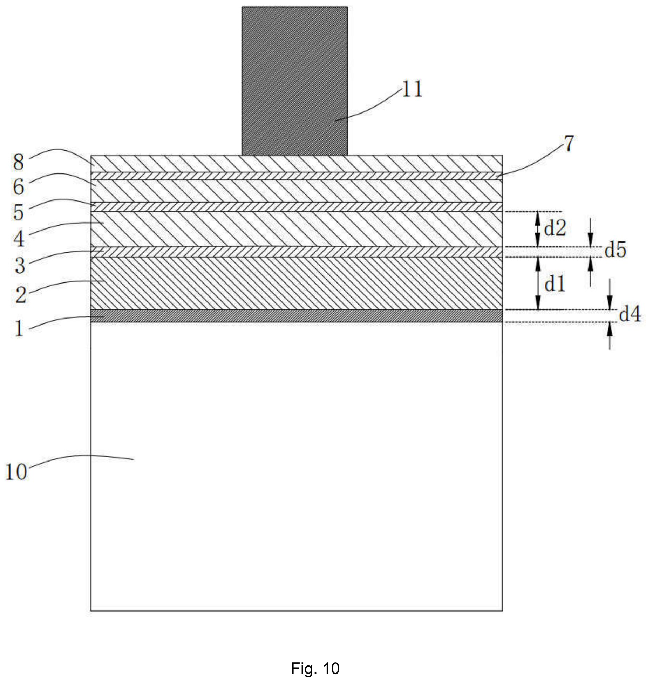

Please refer to Fig. 10, when the doping polarities of the fourth doped polysilicon layer 8 and the third doped polysilicon layer 6 are the same as the doping polarities of the second doped polysilicon layer 4 and the first doped polysilicon layer 2, no opening needs to be provided on the fourth doped polysilicon layer 8 and the third doped polysilicon layer 6, and the first metal electrodes 11 may be in contact with the fourth doped polysilicon layer 8. Certainly, openings may also be provided on the fourth doped polysilicon layer 8, and the first metal electrodes 11 may pass through the openings 100 to be in contact with the third doped polysilicon layer 6. Openings may also be formed on the fourth doped polysilicon layer 8 and the third doped polysilicon layer 6; and the first metal electrodes 11 pass through the openings to be in contact with the second doped polysilicon layer 4 or the first doped polysilicon layer 2.

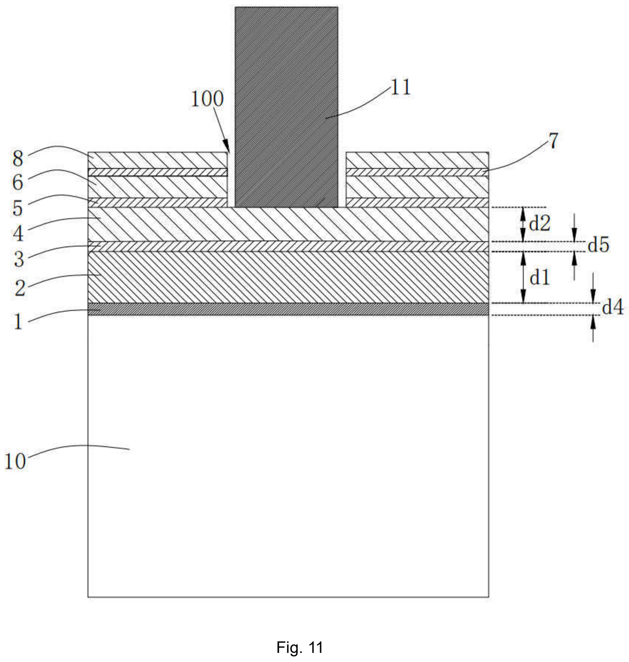

Please refer to Fig. 11, when the doping polarity of the fourth doped polysilicon layer 8 is opposite to the doping polarities of the second doped polysilicon layer 4 and the first doped polysilicon layer 2, openings 100 are provided on the fourth doped polysilicon layer 8, the third barrier layer 7, the third doped polysilicon layer 6 and the first barrier layer 3, and the first metal electrodes 11 pass through the openings 100 to be in contact with the second doped polysilicon layer 4. Certainly, the first metal electrodes 11 may also continue passing through the second doped polysilicon layer 4 and the first barrier layer 3 to be in contact with the first doped polysilicon layer 2.

As an embodiment of the present disclosure, the thickness of the third barrier layer 7 is less than or equal to that of the second barrier layer 5.

In the present embodiment, the thickness of the third barrier layer 7 may be less than or equal to that of the second barrier layer 5, and in some other embodiments, the thickness of the third barrier layer 7 may also be greater than that of the second barrier layer 5. The material of the third barrier layer 7 may be the same as or different from that of the first barrier layer 3.

In other embodiments, the surface of the fourth doped polysilicon layer 8 facing away from the silicon substrate 10 may also be superposed with one or more barrier layers and one or more doped polysilicon layers, to form a laminated structure in which the barrier layers and the doped polysilicon layers are arranged alternately, thereby further improving the cell passivation effect.

### Embodiment 4

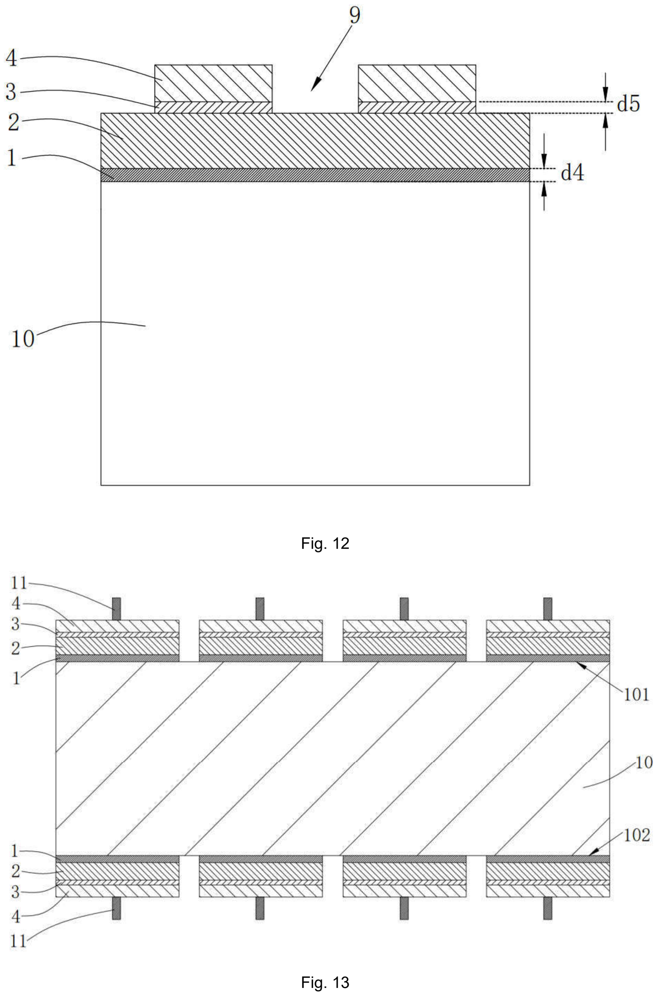

Please refer to Fig. 12, on the basis of any embodiment of Embodiment 1 to Embodiment 3, both the first barrier layer 3 and the second doped polysilicon layer 4 of the solar cell passivation contact structure of the present embodiment are discontinuous structures, so that the first barrier layer 3 and the second doped polysilicon layer 4 cover only a partial region of the first doped polysilicon layer 2.

In the present embodiment, both the first barrier layer 3 and the second doped polysilicon layer 4 are non-continuous and non-full-surface structures,
the first barrier layer 3 and the second doped polysilicon layer 4 are discontinuously provided on the first doped polysilicon layer, so that the first barrier layer 3 and the second doped polysilicon layer 4 are locally passivated. The first barrier layer 3 and the second doped polysilicon layer 4 are both provided in a square pattern on the first doped polysilicon layer 2. Trenches 9 are formed between adjacent first barrier layers 3 and between adjacent second doped polysilicon layers 4. The first metal electrodes 11 are in contact with the first doped polysilicon layer 2 in the region of the trench 9; and the first metal electrodes 11 is located in the region of the second doped polysilicon layer 4 and is in contact with the second doped polysilicon layer 4.

The solar cell passivation contact structure in the present embodiment may be applied to bifacial solar cells, and may also be applied to back contact solar cells.

In the present embodiment, the first barrier layer 3 and the second doped polysilicon layer 4 can be used to further enhance the passivation effect, reduce the areas of the first barrier layer 3 and the second doped polysilicon layer 4, reduce the absorption of light by the doped polysilicon layer, reduce the parasitic absorption, and improve the cell efficiency. On the other hand, during the metallization process of the solar cell, the paste of the first metal electrodes 11 can be blocked between adjacent first barrier layers 3 and between adjacent second doped polysilicon layers 4, allowing thicker paste deposition for the first metal electrodes 11 in the regions not corresponding to the second doped polysilicon layer 4, i.e., thicker paste deposition in the region of the trench 9; therefore, the thickness of the first metal electrodes 11 in the regions not corresponding to the second doped polysilicon layer 4 is greater than the thickness of the first metal electrodes 11 in the regions corresponding to the second doped polysilicon layer 4, thereby increasing the welding tensile strength of the metal electrode, enhancing electrical conductivity, and improving the cell stability.

### Embodiment 5

Please refer to Fig. 13, the present embodiment provides a solar cell, including a silicon substrate 10, where the silicon substrate 10 includes a light-facing surface 101 and a backlight surface 102 arranged opposite to the light-facing surface 101, and at least one of the light-facing surface and the backlight surface is provided with the described solar cell passivation contact structure of any one of Embodiment 1 to Embodiment 4, which can improve the passivation effect of the solar cell, thereby improving the cell efficiency.

In the present embodiment, the solar cell is a bifacial solar cell, both the light-facing surface 101 and the backlight surface 102 of the silicon substrate 10 may be provided with the described solar cell passivation contact structure, or only the light-facing surface 101 or the backlight surface 102 of the silicon substrate 10 may be provided with the described solar cell passivation contact structure.

In the present embodiment, at least one of the light-facing surface 101 and the backlight surface 102 of the solar cell is provided with the described solar cell passivation contact structure of any one of Embodiment 1 to Embodiment 4, so that the back surface of the solar cell has a better passivation effect, and the cell efficiency is improved.

For ease of description, Fig. 13 only illustrates that both the light-facing surface 101 and the backlight surface 102 of the solar cell are provided with the solar cell passivation contact structure of Embodiment 1. A plurality of solar cell passivation contact structures are provided on both the light-facing surface 101 and the backlight surface 102 of the solar cell; the doping polarities of the first doped polysilicon layers 2 of the solar cell passivation contact structures on the light-facing surface 101 are all the same; the doping polarities of the first doped polysilicon layers 2 of the solar cell passivation contact structures on the backlight surface 102 are all the same; furthermore, the doping polarity of the first doped polysilicon layer 2 of each solar cell passivation contact structure on the light-facing surface 101 is opposite to the doping polarity of the first doped polysilicon layer 2 of each solar cell passivation contact structure on the backlight surface 102.

In the present embodiment, all the backlight surface 102 of the solar cell use the solar cell passivation contact structure, so that the solar cell have a good passivation effect, and the cell efficiency is improved.

In the present embodiment, the first metal electrodes 11 of the solar cell passivation contact structure on the light-facing surface 101 correspondingly contact the second doped polysilicon layer 4 or the first doped polysilicon layer 2 of the solar cell passivation contact structure on the light-facing surface 101; the first metal electrodes 11 of the solar cell passivation contact structure on the backlight surface 102 correspondingly contact the second doped polysilicon layer 4 or the first doped polysilicon layer 2 of the solar cell passivation contact structure on the backlight surface 102. One of the first metal electrodes 11 on the light-facing surface 101 and the first metal electrodes 11 on the backlight surface 102 is positive electrodes, and the other is negative electrodes.

In the present embodiment, both the light-facing surface 101 and the backlight surface 102 of the solar cell are provided with the described solar cell passivation contact structure, so as to reduce the inner diffusion of impurities of metal electrodes on the light-facing surface 101 and the backlight surface 102 into the silicon substrate 10, so that both the light-facing surface 101 and the backlight surface 102 have a better passivation effect, the solar cell efficiency is improved, and the metal electrodes on the light-facing surface 101 and the backlight surface 102 are prevented from burning through the silicon substrate 10, thereby improving the cell yield.

In the present embodiment, an isolation region may be provided between the first doped polysilicon layers 2 of two adjacent solar cell passivation contact structures on the light-facing surface 101 and the backlight surface 102 to be isolated from each other, or no isolation region is required, and the first doped polysilicon layers 2 of two adjacent solar cell passivation contact structures may be in contact with each other, which is not limited herein.

### Embodiment 6

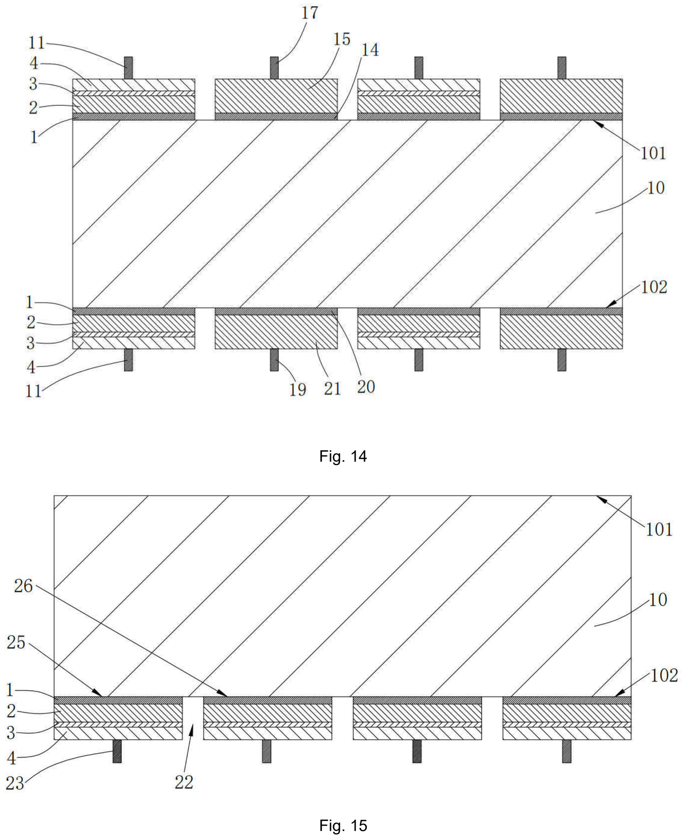

Please refer to Fig. 14, the present embodiment provides a solar cell, including a silicon substrate 10, where the silicon substrate 10 includes a light-facing surface 101 and a backlight surface 102 arranged opposite to the light-facing surface 101, and a local region of the light-facing surface 101 is provided with the described solar cell passivation contact structure of any one of Embodiment 1 to Embodiment 4, which can improve the passivation effect of the solar cell, thereby improving the cell efficiency.

In the present embodiment, the solar cell is a bifacial solar cell. The local region of the light-facing surface 101 is provided with the solar cell passivation contact structure of any one of Embodiment 1 to Embodiment 4, it may be understood that only some regions of the light-facing surface 101 are provided with the solar cell passivation contact structure, and other regions may be provided with other passivation contact structures.

As an embodiment of the present disclosure, a second passivation layer 14, and a fifth doped polysilicon layer 15 which is on the side of the second passivation layer 14 facing away from the silicon substrate 10 are provided on the region of the light-facing surface 101 on which the solar cell passivation contact structure is not provided, the doping polarity of the fifth doped polysilicon layer 15 being the same as that of the first doped polysilicon layer 2.

In the present embodiment, a second passivation layer 14 is provided on the region of the light-facing surface 101 on which the solar cell passivation contact structure is not provided; a fifth doped polysilicon layer 15 is provided on the back surface of the second passivation layer 14; an additional passivation contact structure is formed by using the second passivation layer 14 and the fifth doped polysilicon layer 15; and passivation is performed on the region on which the solar cell passivation contact structure is not provided, so that the cell passivation effect can be further improved.

In the present embodiment, the doping polarity of the fifth doped polysilicon layer 15 is the same as that of the first doped polysilicon layer 2, which may be understood as that: if the doping polarity of the first doped polysilicon layer 2 of the solar cell passivation contact structure is P type, then the doping polarity of the fifth doped polysilicon layer 15 is P type; or, if the doping polarity of the first doped polysilicon layer 2 of the solar cell passivation contact structure is N type, the doping polarity of the fifth doped polysilicon layer 15 is N type.

As a preferred embodiment of the present disclosure, the thickness of the fifth doped polysilicon layer 15 is greater than or equal to that of the first doped polysilicon layer 2 of the solar cell passivation contact structure on the light-facing surface 101. In the present embodiment, the solar cell further includes:
second metal electrodes 17 provided on the light-facing surface 101, the second front metal electrodes 17 being in contact with the fifth doped polysilicon layer 15.

The first metal electrodes 11 of the solar cell passivation contact structure on the light-facing surface 101 is in contact with the second doped polysilicon layer 4 or the first doped polysilicon layer 2; and the first metal electrodes 11 on the light-facing surface 101 and the second metal electrodes 17 on the light-facing surface 101 have the same polarity.

In the present embodiment, the backlight surface 102 of the solar cell may also be provided with the solar cell passivation contact structure of any one of Embodiment 1 to Embodiment 4, and may also be provided with other passivation contact structures.

As an embodiment of the present disclosure, the solar cell passivation contact structure of any one of Embodiment 1 to Embodiment 4 is provided on a local region of the backlight surface 102; and the doping polarity of the first doped polysilicon layer 2 of the solar cell passivation contact structure on the backlight surface 102 is opposite to that of the first doped polysilicon layer 2 of the solar cell passivation contact structure on the light-facing surface 101.

As an embodiment of the present disclosure, a third passivation layer 20, and a sixth doped polysilicon layer 21 which is on the side of the third passivation layer 20 facing away from the silicon substrate 10 are provided on the region of the backlight surface 102 on which the solar cell passivation contact structure is not provided, the doping polarity of the sixth doped polysilicon layer 21 being the same as that of the first doped polysilicon layer 2.

As a preferred embodiment of the present disclosure, the thickness of the sixth doped polysilicon layer 21 is greater than or equal to that of the first doped polysilicon layer 2 of the solar cell passivation contact structure on the backlight surface 102.

As an embodiment of the present disclosure, a solar cell includes:
third metal electrodes 19 provided on the backlight surface 102, the third metal electrodes 19 being in contact with the sixth doped polysilicon layer 21.

In the present embodiment, the first metal electrodes 11 of the solar cell passivation contact structure on the backlight surface 102 is in contact with the second doped polysilicon layer 4 or the first doped polysilicon layer 2; the first metal electrodes 11 and the third metal electrodes 19 on the backlight surface 102 have the same polarity.

As an embodiment of the present disclosure, the first doped polysilicon layer 2 of the solar cell passivation contact structure on the light-facing surface 101 and the fifth doped polysilicon layer 15 where the light-facing surface 101 is located may be arranged at intervals or may also be in contact with each other. The first doped polysilicon layer 2 of the solar cell passivation contact structure on the backlight surface 102 and the sixth doped polysilicon layer 21 where the backlight surface 102 is located may be arranged at intervals or may also be in contact with each other.

### Embodiment 7

Please refer to Fig. 15, the present embodiment provides a solar cell, including a silicon substrate 10, where the silicon substrate 10 includes a light-facing surface 101 and a backlight surface 102 arranged opposite to the light-facing surface 101; and the backlight surface 102 is provided with the described solar cell passivation contact structure of any one of Embodiment 1 to Embodiment 4, which can improve the passivation effect of the solar cell, thereby improving the cell efficiency.

As an embodiment of the present disclosure, the solar cell is a back contact solar cell; the backlight surface 102 of the back contact solar cell is provided with a P region and an N region; and both the P region and the N region are provided with the solar cell passivation contact structure of any one of Embodiment 1 to Embodiment 4. The first doped polysilicon layer 2 of the solar cell passivation contact structure in the P region is P-type doped polysilicon; and the first doped polysilicon layer 2 of the solar cell passivation contact structure in the N region is N-type doped polysilicon.

In the present embodiment, the solar cell is a back contact solar cell; the backlight surface 102 of the back contact solar cell is alternatively provided with P regions 25 and N regions 26; the P region 25 and the N region 26 are respectively provided with the solar cell passivation contact structure of any one of Embodiment 1 to Embodiment 4; and the doping polarities of the first doped polysilicon layers 2 of the two adjacent solar cell passivation contact structures on the backlight surface 102 are opposite, that is, the doping polarities of the first doped polysilicon layer 2 in the P region and the N region are opposite.

In the present embodiment, both the P region 25 and the N region 26 of the backlight surface 102 of the solar cell are provided with the solar cell passivation contact structure of any one of Embodiment 1 to Embodiment 4, since the solar cell passivation contact structures of the P region 25 and the N region 26 each include the first barrier layer 3, the inner diffusion of impurities of metal electrodes of the P region 25 and the N region 26 into the silicon substrate 10 can be reduced by means of the first barrier layer 3, so that both the P region 25 and the N region 26 have a better passivation effect, the back contact solar cell efficiency is improved, and the first barrier layer 3 can prevent the metal electrodes of the P region 25 and the N region 26 from burning through the silicon substrate 10, thereby improving the cell yield. Furthermore, the solar cell passivation contact structures of the P region 25 and the N region 26 each include at least two doped polysilicon layers, which facilitates simultaneously improving the passivation effect of the P region 25 and the N region 26.

In the present embodiment, an isolation region 22 is provided between the first doped polysilicon layers 2 of two adjacent solar cell passivation contact structures, that is, an isolation region 22 is provided between the P region 25 and the N region 26. The isolation region 22 may specifically be a trench, and may also be a gap, so that the solar cell passivation contact structure of the P region 25 and the solar cell passivation contact structure of the N region 26 are kept at intervals; and the first doped polysilicon layers 2 of two adjacent solar cell passivation contact structures are kept at intervals, thereby achieving good isolation between the first doped polysilicon layers 2 of two adjacent solar cell passivation contact structures.

### Embodiment 8

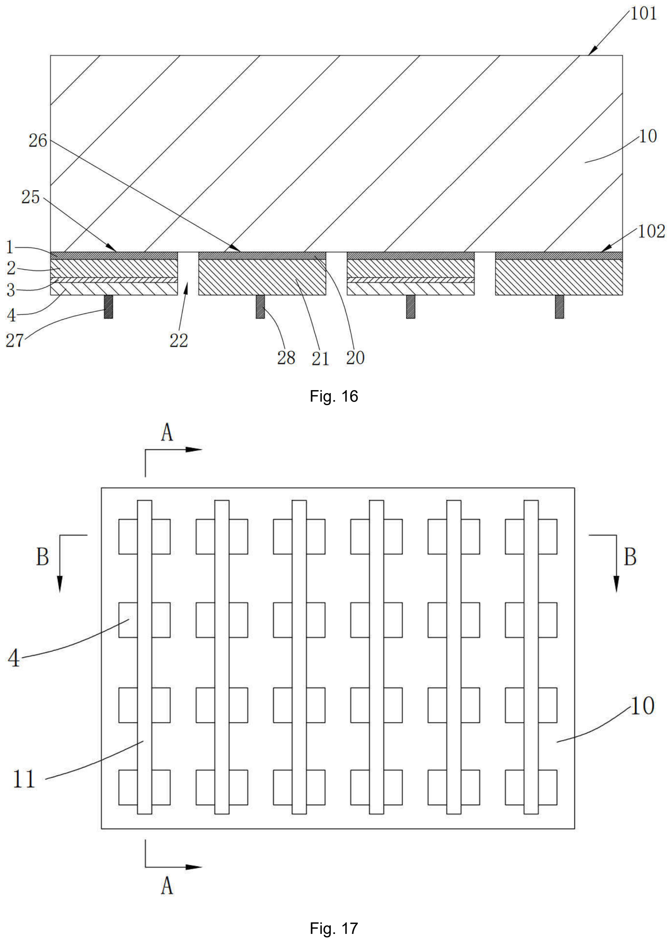

Please refer to Fig. 16, the present embodiment provides a solar cell, including a silicon substrate 10, where the silicon substrate 10 includes a light-facing surface 101 and a backlight surface 102 arranged opposite to the light-facing surface 101; and a local region of the backlight surface 102 is provided with the described solar cell passivation contact structure of any one of Embodiment 1 to Embodiment 4, which can improve the passivation effect of the solar cell.

In the present embodiment, the solar cell is a back contact solar cell; the backlight surface 102 of the back contact solar cell is provided with P regions 25 and N regions 26 which are arranged alternately; and one of the P region and the N region is provided with the solar cell passivation contact structure of any one of Embodiment 1 to Embodiment 4. The backlight surface 102 of the silicon substrate 10 is provided with a plurality of solar cell passivation contact structures, and the doping polarities of the first doped polysilicon layers 2 of two adjacent solar cell passivation contact structures are opposite.

The local region of the backlight surface 102 is provided with the solar cell passivation contact structure of any one of Embodiment 1 to Embodiment 4, it may be understood that only some regions of the backlight surface 102 is provided with the solar cell passivation contact structure, and other regions may be provided with other passivation contact structures.

As an embodiment of the present application, the P region 25 of the backlight surface 102 is provided with the solar cell passivation contact structure of any one of Embodiment 1 to Embodiment 4; the N region 26 of the backlight surface 102 is provided with a third passivation layer 20, and a sixth doped polysilicon layer 21 which is provided on the surface of the third passivation layer 20 facing away from the silicon substrate 10; and the doping polarity of the sixth doped polysilicon layer 21 is opposite to that of the first doped polysilicon layer 2. The solar cell passivation contact structure of any one of Embodiment 1 to Embodiment 4 may also be provided in the N region.

In the present embodiment, the first doped polysilicon layer 2 of the solar cell passivation contact structure of the P region 25 is P-type doped polysilicon; the sixth doped polysilicon layer 21 is N-type doped polysilicon; only the P region 25 is provided with the described solar cell passivation contact structure; the P region 25 utilizes the first barrier layer 3 to block impurities from the metal electrode and the metal electrode paste, reducing the inner diffusion of impurities from the metal electrode of the P region 25 into the silicon substrate 10; additionally, the P region 25 utilizes the first barrier layer 3 to prevent the metal electrode paste from burning through into the silicon substrate 10.

As an embodiment of the present application, the sum of the thicknesses of the first doped polysilicon layer and the second doped polysilicon layer 4 of the solar cell passivation contact structure of the P region 25 is less than the thickness of the sixth doped polysilicon layer of the N region 26. Since the P region 25 is provided with the first barrier layer 3, the thickness of the doped polysilicon layer of the solar cell passivation contact structure of the P region 25 can be reduced; on the premise of using the first barrier layer 3 to block the paste of the metal electrode from being burnt through and to block the metal electrode impurities, the thickness of the first doped polysilicon layer 2 of the P region 25 is reduced, which facilitates reducing costs, and can reduce parasitic absorption of the doped polysilicon layer of the P region 25 and improve the cell efficiency.

As an embodiment of the present application, the thickness of the sixth doped polysilicon layer 21 of the N region 26 is greater than the thickness of the first doped polysilicon layer 2 of the solar cell passivation contact structure of the P region 25. In the present embodiment, the backlight surface 102 of the solar cell use the solar cell passivation contact structure, so that the solar cell have a good passivation effect, and the cell efficiency is improved.

As an embodiment of the present disclosure, the solar cell further includes:
fourth metal electrodes 28 provided on the backlight surface 102, the fourth metal electrodes 28 being in contact with the sixth doped polysilicon layer 21.

In the present embodiment, the first metal electrodes 11 of the solar cell passivation contact structure on the backlight surface 102 is in contact with the second doped polysilicon layer 4 or the first doped polysilicon layer 2; the first metal electrodes 11 on the backlight surface 102 and the fourth metal electrodes 28 on the backlight surface 102 have opposite polarities.

As an embodiment of the present application, the depth that the first metal electrode 11 enter the second doped polysilicon layer 4 is greater than the depth that the fourth metal electrode 28 enter the sixth doped polysilicon layer 21.

In the present embodiment, since the depth that the first metal electrode 11 of the P region 25 enter the second doped polysilicon layer 4 is greater than the depth that the fourth metal electrode 28 of the N region 26 enter the sixth doped polysilicon layer 21, the contact area between the first metal electrode 11 of the P region 25 and the second doped polysilicon layer 4 is increased, and the contact resistance between the first metal electrode 11 and the second doped polysilicon layer 4 is reduced, which facilitates improving the cell efficiency. Meanwhile, since the P region 25 is provided with the described solar cell passivation contact structure, the P region 25 can block the burn-through depth of the paste of the first metal electrodes 11 by utilizing the first barrier layer 3, so as to prevent the paste of the first metal electrodes 11 from diffusing into the first doped polysilicon layer 2 or the silicon substrate, so that the contact performance of the first metal electrodes 11 of the P region 25 and the second doped polysilicon layer 4 can be improved, and the burn-through depth of the first metal electrodes 11 of the P region 25 can be controlled.

As one embodiment of the present disclosure, an isolation region 22 is provided between the P region 25 and the N region 26. The isolation region 22 may specifically be a trench or a gap. The P region 25 and the N region 26 are isolated from each other by means of the isolation region 22, so as to achieve good isolation between the P region 25 and the N region 26. An isolation region 22 is provided between the sixth doped polysilicon layer 21 and the first doped polysilicon layer 2. The isolation region 22 may specifically be a trench or a gap. The isolation region 22 is used to separate the sixth doped polysilicon layer 21 from the first doped polysilicon layer 2, preventing the contact between the sixth doped polysilicon layer 21 and the first doped polysilicon layer 2 and achieving good isolation between the sixth doped polysilicon layer 21 and the first doped polysilicon layer 2.

### Embodiment 9

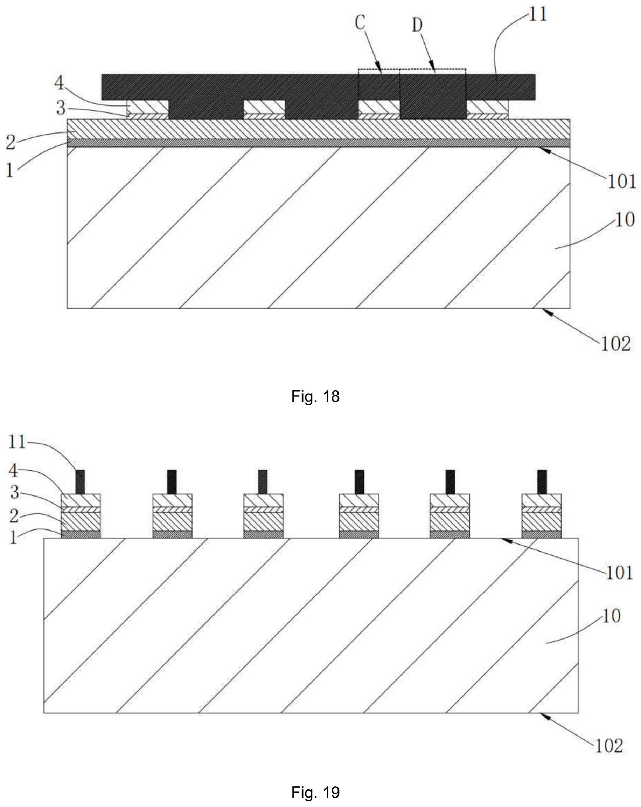

Please refer to Figs. 17-19, the present embodiment provides a solar cell, including a silicon substrate 10, where the silicon substrate 10 includes a light-facing surface 101 and a backlight surface 102 arranged opposite to the light-facing surface 101; and the light-facing surface 101 and/backlight surface 102 is provided with the described solar cell passivation contact structure of Embodiment 4.

In the present embodiment, the solar cell may be a bifacial solar cell or a back contact solar cell. For ease of description, only the light-facing surface 101 of the solar cell shown in Figs. 17 to 19 is provided with the solar cell passivation contact structure of Embodiment 4. Certainly, the backlight surface 102 of the solar cell may also be provided with the solar cell passivation contact structure of Embodiment 4.

In the present embodiment, since the first barrier layer 3 and the second doped polysilicon layer 4 of the solar cell passivation contact structure are both non-continuous and non-full-surface structures, the first barrier layer 3 and the second doped polysilicon layer 4 are discontinuously provided on the first doped polysilicon layer 2. The first metal electrodes 11 of the solar cell passivation contact structure is in contact with the second doped polysilicon layer 4 or the first doped polysilicon layer 2.

In the present embodiment, the first barrier layer 3 and the second doped polysilicon layer 4 can be used to further enhance the passivation effect, can reduce the areas of the first barrier layer 3 and the second doped polysilicon layer 4, reduce the absorption of light by the doped polysilicon layer, thus reduce the parasitic absorption, and improve the cell efficiency. On the other hand, during the metallization process of the solar cell, the paste of the first metal electrodes 11 can be blocked between adjacent first barrier layers 3 and between adjacent second doped polysilicon layers 4, so that the thickness of the first metal electrodes 11 corresponding to the region D without the second doped polysilicon layer 4 is greater than the thickness of the first metal electrodes 11 corresponding to the region C of the second doped polysilicon layer 4, that is, the first metal electrodes 11 corresponds to the position of the non-second doped polysilicon layer 4, and the paste of the first metal electrodes 11 is deposited to be thicker, which facilitates increasing the welding tensile strength of the first metal electrodes 11, and improving the conductivity of the first metal electrodes 11 and the stability of the solar cell.

### Embodiment 10

An embodiment of the present application further provides a solar module, including the solar cell of the foregoing embodiment. It should be noted that, the solar module has the same or similar beneficial effects as the described back contact solar cell, and the relevant parts between the two can refer to each other, and is not described herein again to avoid repetition.

### Embodiment 11

An embodiment of the present application further provides a photovoltaic system including the solar module of Embodiment 9. It should be noted that the photovoltaic system has the same or similar beneficial effects as those of the described solar cell, and the relevant parts between the two can refer to each other, and is not described herein again to avoid repetition.

The present disclosure provides a solar cell passivation contact structure including:
a first passivation layer, a first doped polysilicon layer, a first barrier layer and a second doped polysilicon layer which are sequentially stacked on a surface of a silicon substrate; by adding the first barrier layer and the second doped polysilicon layer on the surface of the first doped polysilicon layer, the combined blocking effect of the first passivation layer and the first barrier layer is utilized to prevent excessive diffusion of impurities from the metal electrodes, such as iron, copper, cobalt, nickel, and chromium, into the silicon substrate, which significantly enhances the passivation effect of the solar cell, thereby improving cell efficiency; in addition, the first barrier layer can block the metal electrode paste, reducing the burn-through depth of the metal electrode paste and preventing the metal electrodes from burning through the first barrier layer into the first doped polysilicon layer, thus improving the cell yield;
furthermore, the thickness of the first passivation layer is set to be greater than that of the first barrier layer; by reducing the thickness of the first barrier layer, it facilitates the diffusion of doping atoms from the first doped polysilicon layer and the second doped polysilicon layer through the first barrier layer; doping atoms from the one of the first doped polysilicon layer and the second doped polysilicon layer with a higher doping concentration can diffuse through the first barrier layer to one of the first doped polysilicon layer and the second doped polysilicon layer with a lower doping concentration, thereby better adjusting the doping concentrations of the first doped polysilicon layer and the second doped polysilicon layer, which further enhances the passivation effect of the solar cell passivation contact structure; this not only allows the first barrier layer to block impurities from the metal electrodes and prevent burn-through by the metal electrode paste, but also facilitates the adjustment of doping concentrations between the first doped polysilicon layer and the second doped polysilicon layer, achieving a balance between both effects and thereby further enhancing the efficiency of the solar cell.

The described content merely relates to preferred embodiments of the present disclosure, and is not intended to limit the present disclosure, and any modifications, equivalent replacements, improvements, etc. made within the spirit and principle of the present disclosure shall all fall within the scope of protection of the present disclosure.

## Claims

1. A solar cell passivation contact structure, comprising a first passivation layer, a first doped polysilicon layer, a first barrier layer and a second doped polysilicon layer which are sequentially stacked on a surface of a silicon substrate, wherein a doping polarity of the first doped polysilicon layer is same as that of the second doped polysilicon layer, and a thickness of the first passivation layer is greater than that of the first barrier layer.

2. The solar cell passivation contact structure according to claim 1, wherein a ratio of the thickness of the first passivation layer to that of the first barrier layer is 1 to 10 and not equal to 1.

3. The solar cell passivation contact structure according to claim 1, wherein a ratio of the thickness of the first passivation layer to that of the first barrier layer is 1 to 4 and not equal to 1.

4. The solar cell passivation contact structure according to claim 1, wherein a ratio of the thickness of the first passivation layer to that of the first barrier layer is 1 to 2 and not equal to 1.

5. The solar cell passivation contact structure according to claim 1, wherein the thickness of the first passivation layer is 0.5 to 5 nm, and a thickness of the first barrier layer is 0.2 to 4.5 nm.

6. The solar cell passivation contact structure according to claim 1, wherein the first passivation layer is provided with through holes, and the first doped polysilicon layer is in contact with the silicon substrate through the through holes of the first passivation layer.

7. The solar cell passivation contact structure according to claim 1, wherein the first barrier layer is provided with through holes, and the second doped polysilicon layer is in contact with the first doped polysilicon layer through the through holes of the first barrier layer.

8. The solar cell passivation contact structure according to claim 1, wherein both the first passivation layer and the first barrier layer are provided with through holes, and a through hole density of the first passivation layer is less than that of the first barrier layer.

9. The solar cell passivation contact structure according to claim 1, wherein both the first passivation layer and the first barrier layer are provided with through holes, and an average diameter of the through holes of the first passivation layer is less than an average diameter of the through holes of the first barrier layer.

10. The solar cell passivation contact structure according to claim 1, wherein the first passivation layer comprises one or a combination of silicon oxide containing boron, phosphorus or gallium, silicon oxynitride containing boron, phosphorus or gallium, and silicon nitride containing boron, phosphorus or gallium.

11. The solar cell passivation contact structure according to claim 1, wherein the first barrier layer comprises one or a combination of silicon oxide containing boron, phosphorus or gallium, silicon oxynitride containing boron, phosphorus or gallium, silicon nitride containing boron, phosphorus or gallium, oxygen-rich silicon containing boron, phosphorus or gallium, and nitrogen-rich silicon containing boron, phosphorus or gallium.

12. The solar cell passivation contact structure according to claim 11, wherein an oxygen content of the oxygen-rich silicon is 1×10¹⁹ atoms/cm³ or more.

13. The solar cell passivation contact structure according to claim 11, wherein a nitrogen content of the nitrogen-rich silicon is 1×10¹⁹ atoms/cm³ or more.

14. The solar cell passivation contact structure according to claim 1, wherein the first passivation layer, the first doped polysilicon layer, the first barrier layer and the second doped polysilicon layer are all doped with group IIIA or group VA elements; and a doping concentration of the second doped polysilicon layer is greater than that of the first doped polysilicon layer.

15. The solar cell passivation contact structure according to claim 14, wherein the doping concentration of the first passivation layer is less than or equal to that of the first barrier layer.

16. The solar cell passivation contact structure according to claim 1, wherein a thickness of the first doped polysilicon layer is greater than that a thickness of the second doped polysilicon layer.

17. The solar cell passivation contact structure according to claim 1, wherein a ratio of a thickness of the first doped polysilicon layer to a thickness of the second doped polysilicon layer is 1 to 50.

18. The solar cell passivation contact structure according to claim 17, wherein the ratio of the thickness of the first doped polysilicon layer to the thickness of the second doped polysilicon layer is 2 to 50.

19. The solar cell passivation contact structure according to claim 18, wherein the ratio of the thickness of the first doped polysilicon layer to the thickness of the second doped polysilicon layer is 5 to 50.

20. The solar cell passivation contact structure according to claim 16, wherein a ratio of the thickness of the first doped polysilicon layer to the thickness of the second doped polysilicon layer is 10 to 50.

21. The solar cell passivation contact structure according to claim 16, wherein the thickness of the first doped polysilicon layer is 30 to 350 nm, and the thickness of the second doped polysilicon layer is 5 to 150 nm.

22. The solar cell passivation contact structure according to claim 1, wherein a thickness of the first doped polysilicon layer is less than that of the second doped polysilicon layer.

23. The solar cell passivation contact structure according to claim 1, further comprising:
a second barrier layer provided on a side of the second doped polysilicon layer facing away from the silicon substrate.

24. The solar cell passivation contact structure according to claim 23, wherein a thickness of the second barrier layer is less than or equal to that of the first barrier layer.

25. The solar cell passivation contact structure according to claim 23, further comprising:
a third doped polysilicon layer provided on a side of the second barrier layer facing away from the silicon substrate, a doping polarity of the third doped polysilicon layer being same as or opposite to the doping polarity of the second doped polysilicon layer.

26. The solar cell passivation contact structure according to claim 25, further comprising:
a third barrier layer provided on a side of the third doped polysilicon layer facing away from the silicon substrate.

27. The solar cell passivation contact structure according to claim 26, further comprising:
a fourth doped polysilicon layer provided on a side of the third barrier layer facing away from the silicon substrate, a doping polarity of the fourth doped polysilicon layer being same as or opposite to the doping polarity of the second doped polysilicon layer.

28. The solar cell passivation contact structure according to claim 27, wherein a thickness of the third barrier layer is less than or equal to that of the second barrier layer.

29. The solar cell passivation contact structure according to claim 1, wherein both the first barrier layer and the second doped polysilicon layer are discontinuously provided on the first doped polysilicon layer.

30. The solar cell passivation contact structure according to claim 27, wherein thicknesses of the first doped polysilicon layer, the second doped polysilicon layer, the third doped polysilicon layer, and the fourth doped polysilicon layer decrease sequentially.

31. The solar cell passivation contact structure according to claim 1, further comprising:
a plurality of first metal electrodes provided on the second doped polysilicon layer, the plurality of first metal electrodes being in contact with the second doped polysilicon layer.

32. The solar cell passivation contact structure according to claim 31, wherein the plurality of first metal electrodes pass through the second doped polysilicon layer and the first barrier layer to be in contact with the first doped polysilicon layer.

33. The solar cell passivation contact structure according to claim 32, wherein a width of the first metal electrode in a region of the first doped polysilicon layer is less than that of the first metal electrode in a region of the second doped polysilicon layer.

34. A solar cell, comprising a silicon substrate, wherein the silicon substrate comprises a light-facing surface and a backlight surface provided opposite the light-facing surface, and at least one of the light-facing surface and the backlight surface is provided with the solar cell passivation contact structure according to any one of claims 1-33.

35. The solar cell according to claim 34, wherein the solar cell is a back contact solar cell, the backlight surface of the back contact solar cell is provided with a P region and an N region, and at least one of the P region and the N region is provided with the solar cell passivation contact structure.

36. The solar cell according to claim 35, wherein the P region is provided with the solar cell passivation contact structure, the N region is provided with a third passivation layer and a sixth doped polysilicon layer provided on a surface of the third passivation layer facing away from the silicon substrate; the first doped polysilicon layer of the solar cell passivation contact structure of the P region is P-type doped polysilicon, and the sixth doped polysilicon layer is N-type doped polysilicon.

37. The solar cell according to claim 35, wherein both the P region and the N region are provided with the solar cell passivation contact structure, the first doped polysilicon layer of the solar cell passivation contact structure in the P region is P-type doped polysilicon, and the first doped polysilicon layer of the solar cell passivation contact structure in the N region is N-type doped polysilicon.

38. A solar module, comprising the solar cell according to any one of claims 34 to 37.

39. A photovoltaic system, comprising the solar module according to claim 38.
